## Europäisches Patentamt

## European Patent Office

## Office européen des brevets

(11) Publication number: **0 183 996**
**B1**

(12) **EUROPEAN PATENT SPECIFICATION**

(45) Date of publication of patent specification: **05.12.90**

(51) Int. Cl.⁵: **G 01 R 27/26, G 01 R 31/26**

(21) Application number: **85113911.3**

(22) Date of filing: **31.10.85**

(54) Apparatus for measuring an AC electrical parameter of a device.

(30) Priority: **02.11.84 JP 232224/84**

(43) Date of publication of application:
**11.06.86 Bulletin 86/24**

(45) Publication of the grant of the patent:
**05.12.90 Bulletin 90/49**

(84) Designated Contracting States:
**DE FR GB IT NL**

(56) References cited:

**REVIEW OF SCIENTIFIC INSTRUMENTS, vol. 52,
no. 12, December 1981, pages 1905-1909, New
York, US; L.J.P. KETELSEN "Computer-assisted
system for measuring capacitance and
conductance of a diode using a phase sensitive
technique"**

(73) Proprietor: **Hewlett-Packard Company
3000 Hanover Street
Palo Alto California 94304 (US)**

(72) Inventor: **Bach, Heinz-Gunter, Dr.
Bahnhofstrasse 4
D-1000 Berlin 49 (DE)**
Inventor: **Dressler, Wolfgang
Wulfsheinstrasse 1
D-1000 Berlin 10 (DE)**

(74) Representative: **Schulte, Knud, Dipl.-Ing.
c/o Hewlett-Packard GmbH Europ. Patent- und
Lizenzabteilung Postfach 1430 Herrenberger
Strasse 130
D-7030 Böblingen (DE)**

Courier Press, Leamington Spa, England.

## Description

The present invention relates to an apparatus for measuring an AC electrical parameter of a device in accordance with the preamble to claim 1. The AC electrical parameter may be a resistance, an impedance or another parameter. DC bias is applied to the device during measurement concurrently with the application of an AC measurement signal.

From L.J.P. Ketelsen et al.: "Computer-assisted system for measuring capacitance and conductance of a diode using a phase sensitive technique", REVIEW OF SCIENTIFIC INSTRUMENTS; Vol. 52, No. 12, December 1981, pages 1905—1909, an apparatus for measuring an AC electrical parameter of a device under test is known which comprises a DC source for biasing the device under test. The bias voltage can be incremented upon command from a computer. The bias circuit comprises a 12-V car battery and a motor driven potentiometer. The potentiometer is controlled by a digital output part of the computer.

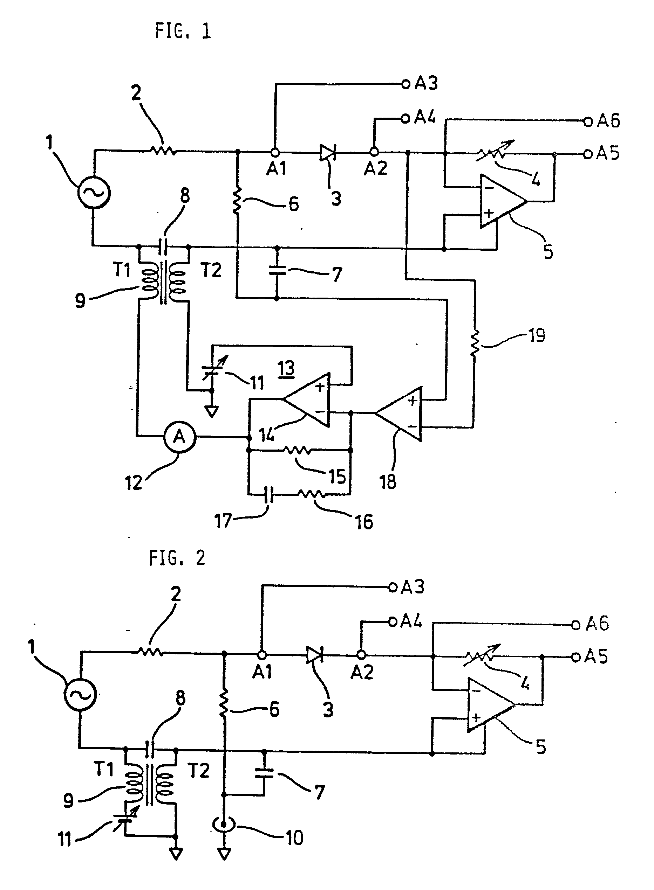

A known apparatus in accordance with the claim preamble (Hewlett-Packard Model 4275A LCR Meter) wherein an AC measurement signal and a DC bias signal are provided to the sample concurrently for measurement, has a circuit configuration as shown in Figure 2. The purpose of providing a DC bias signal concurrently with an AC measurement signal is to obtain the characteristic of a device under test, for example a diode, by measuring its conductance, capacitance or another parameter with DC bias to establish an operating point and AC signal applied to measure the parameter. In the known circuit, a selectable value of the DC bias signal can be supplied and measured at an output port for monitoring purposes.

In Figure 2, AC power source 1 is connected via source resistor 2 to terminal A1 serving as a connector for device under test 3. A second terminal A2 for connection to device under test (DUT) 3 is connected to a first terminal of range resistor 4 having selectable predetermined values, and to measurement terminal A6 and an inverting input terminal of operational amplifier 5. Terminals A1, A2 are connected to measurement terminals A3, A4, respectively. DUT 3 may be, for example, a Schottky diode or a PN junction diode which is connected between terminals A1 and A2. The second terminal of variable range resistor 4 is connected to the output terminal of operational amplifier 5. The output terminal of operational amplifier 5 is also connected to measurement terminal A5. The non-inverting input terminal of operational amplifier 5 and its reference terminal are connected to AC power source 1 via capacitor 8. A first terminal of capacitor 7 is connected to the connection between resistor 6 and monitoring terminal 10; the other terminal of capacitor 7 is connected to the non-inverting terminal of operational amplifier 5. The terminals of capacitor 8 are connected respectively to a primary winding T1 and a secondary winding T2 of transformer 9. Capacitor 8 and transformer 9 serve to prevent AC signal from flowing to DC power source 11 and to the reference potential. The other terminal of primary winding T1 is connected to the reference potential via variable DC power source 11. The second terminal of secondary winding T2 is connected directly to the reference potential, which may be ground.

The output voltage and output frequency of AC power source 1 and the value of variable range resistor 4 are controlled by a control circuit which is not shown in Figure 2. The measurement mechanism of the known circuit shown in Figure 2 will now be explained.

DC current source 11 serves to bias DUT 3 by generating a current flowing through primary winding T1 of transformer 9, AC power source 1, source resistor 2, DUT 3, variable range resistor 4, operational amplifier 5, and secondary winding T2 of transformer 9 to the ground connection of power source 11. Because terminal A2 is held at virtual ground by operational amplifier 5, the DC voltage at terminal A1 connected to DUT 3 can be measured by connecting a voltmeter to monitoring terminal 10. Resistor 6 and capacitor 7 serve to shunt any AC signal on monitoring terminal 10 to the reference potential to ensure freedom from AC interference in the measurement of DC bias at monitoring terminal 10. The AC current from AC power source 1 flows through source resistor 2, DUT 3, variable range resistor 4, operational amplifier 5, capacitor 8 and back to AC power source 1.

The frequency-conductance characteristics of DUT 3 at a selected bias voltage may be measured as follows. First the output voltage of DC power source 11 is set to the selected value to provide a constant DC voltage to DUT 3. AC current at a desired frequency is provided by AC power source 1. By means of the circuit controlling the variable range resistor 4, which is not shown, an appropriate value of variable range resistor 4 is automatically selected after the setup of DC power source 11 and AC power source 1 for accommodation of the selected signal levels. The conductance of DUT 3 at the selected frequency can now be obtained from a quadrature measurement of AC voltage across measurement terminals A3 and A4 and measurement terminals A5 and A6, respectively. By sweeping the output frequency of AC power source 1, the frequency-conductance characteristics of DUT 3 may be obtained.

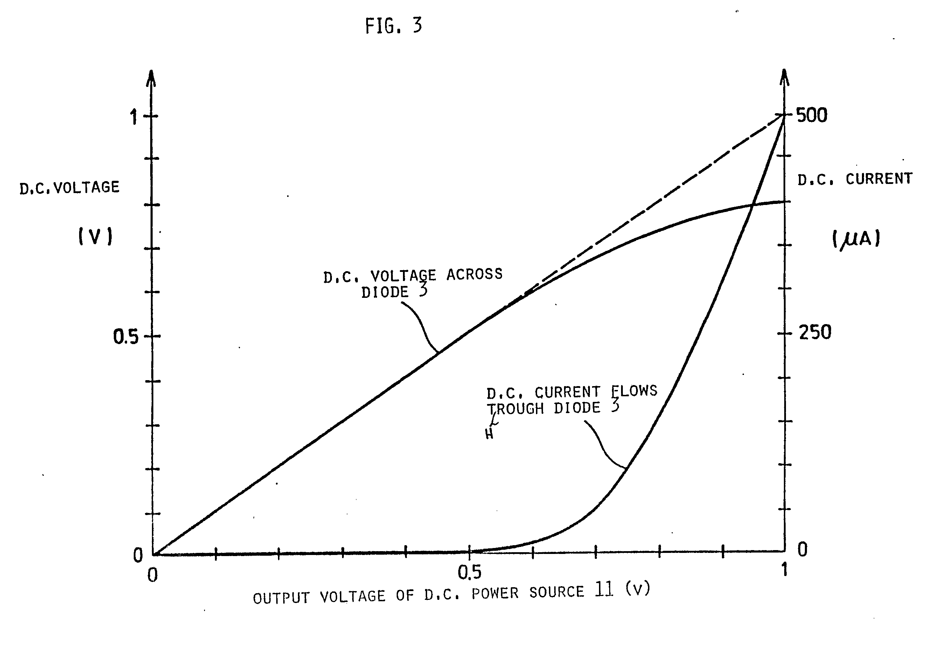

It has been found, however, that in the known apparatus the selected DC bias voltage which is the output voltage of DC power source 11, is not equal to the DC voltage across DUT 3. A problem arises from measuring the DC voltage at monitoring terminal 10 as will be explained in the following. In Figure 3, the result of a measurement is shown as a plot of DC voltage across and DC current through DUT 3 versus the output voltage of DC power source 11 within the measurement apparatus of Figure 2. As shown in the Figure, the DC current flowing through diode 3 increases considerably along with the increase in the output voltage of DC power source 11. When the output voltage of DC power source 11 is 1 V, a DC voltage across diode 3 of 0.8 V results, which is equivalent to an error of 20% in the DC bias value. Thus it turns out that the DC voltage across diode 3 is not equal to the output voltage of DC power source 11 which gives rise to a significant error in measurement of, for example, conductance versus applied DC voltage bias. Obviously, the current flowing through the DUT will give rise to a voltage drop by source resistor 2 producing a deviation in voltage at the DUT from the value at the output of an ideal DC voltage source 11, but this is accounted for by the location of monitoring terminal 10. Thus the error occurs irrespective of monitoring terminal 10 being placed directly after source resistor 2 in immediate contact with connecting terminal A1.

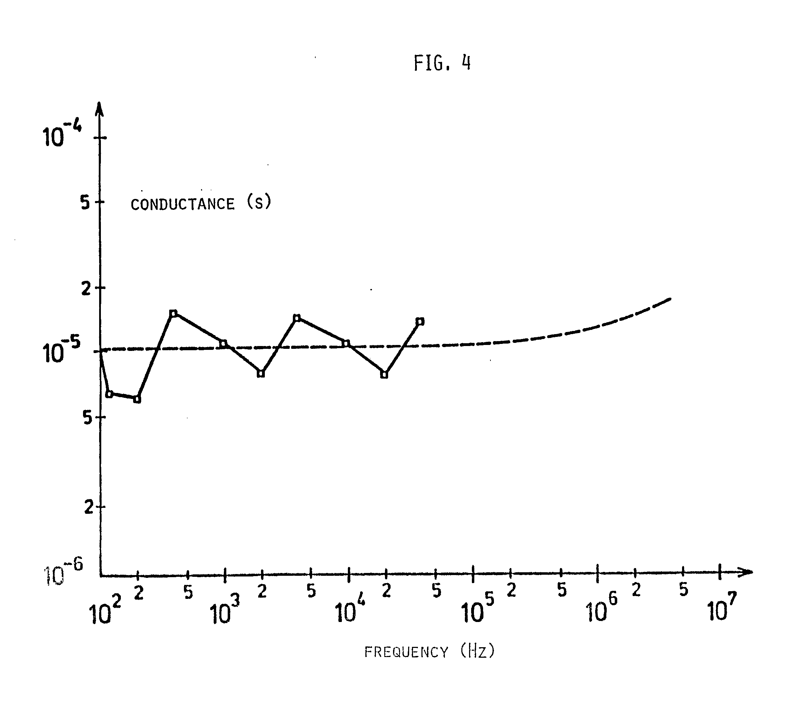

An investigation showed that operational amplifier 5, which is of a broad-band, high-frequency design, is the main cause of measurement error. Being a real circuit, its gain is finite so that its input impedance (which is approximately equal to the resistance value of variable range resistor 4 divided by the gain) is not equal to zero, and operational amplifier 5 may show significant DC offset voltage across its input terminals. Furthermore, the DC input impedance of operational amplifier 5 and the DC offset voltage across its input terminals fluctuates with the variation of value in variable range resistor 4 which leads to changes in the voltage at terminal A2 which should be, however, at virtual ground for the measurement of DC bias at monitoring terminal 10 to be correct. Accordingly, the DC voltage measured at monitoring terminal 10 is not equivalent to the DC voltage bias across DUT 3. Figure 4 shows the effect of the described error on the accuracy of conductance measurement when the output voltage of DC power source 11 is set to 2.5 V and the output current is set of 1A.

In Figure 4, the curve drawn with a solid line results from a measurement of a diode with the apparatus shown in Figure 2. Considerable fluctuation in the measured conductance value can be observed which results from the changes in the value of variable range resistor 4 which is changed over in correspondence to the magnitude of AC current flowing through diode 3. The errors produced by the apparatus shown in Figure 2 are particularly detrimental to measurements of doping characteristics of diodes 3 which can be obtained by combining the results of a frequency-conductance measurement and a bias voltage-capacitance measurement, because the two measurements must be performed with high accuracy for the measurement of doping characteristics to be useful. Therefore, the known measurement apparatus cannot be applied to such a measurement because of its inherent large measurement error which arises from the fact that the voltage across diode 3 is not precisely measured by the monitoring terminal which is connected to only one of the diode terminals. Thus it was impossible with the known apparatus to produce highly accurate frequency-conductance measurements, bias voltage-capacitance measurements etc. Even if a voltmeter were connected for monitoring the DC voltage across diode 3, the output voltage of DC power source 11 would be required to be reset whenever variable range resistor 4 is changed over.

It is a primary object of the present invention to provide an apparatus for measuring an AC electrical parameter of a device in accordance with the preamble to claim 1 wherein the AC characteristics of the device may be obtained with high accuracy of the DC bias signal applied across the sample.

In accordance with claim 1, this object is achieved by providing control means coupled to sense the DC bias voltage across the device and coupled to the DC signal source for regulating the DC bias voltage across the device to a selectable value.

The subclaims are directed to preferred embodiments of the invention as follows:

In accordance with claim 2, the invention is of particular advantage in an apparatus wherein the finite gain and/or other imperfections in the DC performance of a high bandwidth, high-frequency current sense amplifier are the primary cause of errors in the DC bias signal.

By controlling the voltage on the second terminal which is not connected to the current sensing amplifier, the DC bias signal can be regulated to the desired value independently from any effects that the amplifier may have. DC bias signal accuracy thus is improved without any need for design changes in the amplifier. Claims 3 and 4 are directed to specific simple circuit designs.

An exemplary embodiment of the invention will now be described in detail with reference to the accompanying drawings, wherein

Figure 1 is a block diagram of an apparatus for measuring an AC electrical parameter of a device, in accordance with the present invention;

Figure 2 is a block diagram of an apparatus for measuring an AC electrical parameter, of prior art;

Figure 3 illustrates the fluctuation of the bias voltage observed in the apparatus shown in Figure 2; and

Figure 4 shows the frequency-conductance characteristics of a diode measured first by the prior art apparatus and second by an apparatus in accordance with the present invention.

Figure 1 is a block diagram of an apparatus for measuring an AC electrical parameter of a device, in accordance with the present invention. The reference designators and numbers used in Figure 1 correspond to the designations used in Figure 2. Because the flow path of the AC signal is very similar to the flow path described in connection with the prior art Figure 2, the description thereof will not be repeated here. The DC current flow path within the apparatus which includes a control circuit to set a fixed value of DC voltage across DUT 3 will now be described.

In Figure 1, a non-inverting input terminal of an operational amplifier 18 whose gain is 1, is connected via a resistor 6 to terminal A1. Its inverting input terminal is connected through a resistor 19 to terminal A2 and its output terminal is connected to an inverting input terminal of an operational amplifier 14. A non-inverting input terminal of an operational amplifier 14 is connected to the DC power source 11. Resistors 15 and 16 and capacitor 17 are connected between the inverting input terminal and the output terminal of operational amplifier 14. The combination of operational amplifier 14, resistors 15 and 16 and capacitor 17 forms a regulating amplifier 13. The output terminal of operational amplifier 14 is connected to primary winding T1 of transformer 9 via an amperemeter 12.

The difference in voltage between the output voltage of DC power source 11 and the output voltage of amplifier 18 is amplified by amplifier 13, then flows through amperemeter 12, primary winding T1, AC power source 1, resistor 2, DUT 3, variable range resistor 4, operational amplifier 5, secondary winding T2 and to the grounded terminal of DC power source 11. Substantially no current flows through resistor 6 and 19 because the input impedance of amplifier is of considerable magnitude, so that the DC voltage drop across DUT 3 serves as the input value to the input terminals of amplifier 18. By virtue of the amplification factor of amplifier 18 being 1, the DC voltage across DUT 3 is directly input to the inverting input terminal of operational amplifier 14. The differential in voltage between the DC voltage across DUT 3 and the output voltage of DC power source 11 thus is the voltage amplified by amplifier 13. The combination of amplifier 13, amperemeter 12, primary winding T1, AC power source 1, resistor 2, DUT 3, resistors 6 and 19 and amplifier 18 comprises a regulating loop circuit. The loop circuit is stabilized at its quiescent value when the output voltage of DC power source 11 and the output voltage of amplifier 18 are equivalent. Thus the loop circuit serves to set the DC voltage across DUT 3 to the value prescribed by the output voltage of DC power source 11; this actual DC bias voltage can be changed to any desired value by changing the output voltage of DC power source 11. After settlement to the desired value of the output voltage of DC power source 11, the AC characteristics of diode 3 can then be measured in accordance with the measurement procedure known in the art and described with reference to Figure 2. The experimental result of a frequency-conductance measurement of a diode 3 with a measurement apparatus in accordance with the present invention is illustrated in Figure 4 with a dotted line, and the enhancement in measurement accuracy is readily observed.

Although the gain of operational amplifier 18 in the illustrated embodiment of the inventin is chosen to be the value of 1, it should be obvious to anyone skilled in the art that any different value of amplification factor may be selected if the remainder of the circuit is properly designed in accordance therewith.

In accordance with the present invention, a stable and precisely controlled DC bias voltage can be provided in an apparatus in accordance with the preamble to claim 1 by controlling the voltage across the device under test in comparison with a reference voltage. A significant enhancement in accuracy of measurement of AC characteristics results, and any effect of fluctuation caused by changing over the variable range resistor and by other factors is reduced. An additional advantage is that an amperemeter may be included within the loop circuit without affecting its operation because its resistance is accounted for by the regulatory action of the loop, so that the value of DC bias current flowing through the device under test may be read off the amperemeter immediately.

## Claims

1. An apparatus for measuring an AC electrical parameter of a device (3) when connected thereto, comprising
a DC signal source (11) for generating a DC bias signal for the device (3) during measurement,
a first terminal (A2) for connection to the device (3),
a current sensing amplifier (4, 5) for pulling the first terminal (A2) to virtual ground potential,
a second terminal (A1) for connection to the device (3), said second terminal being coupled to the DC signal source (11) for receiving the DC bias signal, characterized in that to compensate for DC offset and/or finite gain of the current sensing amplifier (4, 5), control means (13, 18) is provided coupled to sense the DC bias voltage across the device (3) and coupled to the DC signal source (11) for regulating the DC bias voltage across the device to a selectable value, said control means being operative to increase the potential of the second terminal (A1) in response to an increase in the potential of the first terminal (A2) and to decrease the potential of the second terminal (A1) in response to a decrease in potential of the first terminal (A2) so as to keep the difference in potential between the first and the second terminal at the selectable value.

2. An apparatus as in claim 1, characterized in that the control means (13, 18) comprises:
a difference amplifier (18) for sensing the DC bias voltage between the first and the second terminal, having a first input port coupled to the first terminal (A2), a second input port coupled to the second terminal (A1) and an output port for developing a sense signal representative of the sensed DC bias voltage; and a control amplifier (13) having a first input port coupled to receive the sense signal, a second input port coupled to the DC signal source (11) for receiving the DC bias signal and an output port coupled to the second terminal (A1); and further characterized in that the control amplifier (13) is operative to change the voltage at the second terminal (A1) in response to the sense signal being different from the DC bias signal.

3. An apparatus as in claim 1 or 2, characterized in that the DC signal source (11) is an adjustable DC voltage source and that the control means (13, 18) is operative to regulate the DC bias voltage across the device under test (3) to the output voltage of the DC voltage source (11).

**Patentansprüche**

1. Vorrichtung zum Messen eines elektrischen Wechselstromparameters eines damit verbindbaren Bauelementes (3), mit folgenden Merkmalen:
   eine Gleichspannungssignalquelle (11) zum Erzeugen eines Gleichstrom-Vorspannungssignales für das Bauelement (3) während der Messung,
   ein erster Anschluß (A2) zur Verbindung mit dem Bauelement (3),
   ein Stromerfassungsverstärker (4, 5), welcher den ersten Anschluß (A2) auf virtuelles Massepotential zieht,
   ein zweiter Anschluß (A1) zur Verbindung mit dem Bauelement (3), wobei der zweite Anschluß an die Gleichspannungssignalquelle (11) gekoppelt ist zum Empfang des Gleichstrom-Vorspannungssignals, dadurch gekennzeichnet, daß zum Kompensieren von Gleichspannungsoffset und/oder endlicher Verstärkung des Stromerfassungsverstärkers (4, 5) eine Steuereinrichtung (13, 18) vorgesehen ist, welche das Gleichstrom-Vorspannungssignal über dem Bauelement (3) erfaßt, und welche an die Gleichspannungssignalquelle (11) gekoppelt ist, um die Gleichstrom-Vorspannung über dem Bauelement auf einen wählbaren Wert zu regeln, wobei die Steuereinrichtung das Potential des zweiten Anschlusses (A1) als Folge einer Erhöhung des Potentials des ersten Anschlusses (A2) erhöht, und da Potential des zweiten Anschlusse (A1) als Folge einer Erniedrigung des Potentials des ersten Anschlusses (A1) als Folge einer des Potentials des ersten Anschlusses (A2) erniedrigt, so daß die Potentialdifferenz zwischen dem ersten und dem zweiten Anschluß auf dem wählbaren Wert gehalten wird.

2. Vorrichtung gemäß Anspruch 1, dadurch gekennzeichnet, daß die Steuereinrichtung (13, 18) umfaßt:
   einen Differenzverstärker (18) zum Erfassen der Gleichstrom-Vorspannung zwischen dem ersten und dem zweiten Anschluß, mit einer ersten Eingangsstelle, die an den ersten Anschluß (A2) gekoppelt ist, einer zweiten Eingangsstelle, die an den zweiten Anschluß (A1) gekoppelt ist und einer Ausgangsstelle zum Erzeugen eines Erfassungssignales, welches repräsentativ für die erfaßte Gleichstrom-Vorspannung ist; und einen Steuerverstärker (13) mit einer ersten Eingangsstelle zum Empfangen des Erfassungssignals, einer zweiten Eingangsstelle, welche an die Gleichspannungssignalquelle (11) gekoppelt ist zum Empfangen des Gleichstrom-Vorspannungssignals und eine Ausgangsstelle, welche an den zweiten Anschluß (A1) gekoppelt ist; und weiterhin dadurch gekennzeichnet, daß der Steuerverstärker (13) die Spannung an dem zweiten Anschluß (A1) als Folge einer Abweichung des Erfassungssignales von dem Gleichstrom-Vorspannungssignal ändert.

3. Vorrichtung gemäß Anspruch 1 oder 2, dadurch gekennzeichnet, daß die Gleichspannungssignalquelle (11) eine einstellbare Gleichspannungsquelle ist und daß die Steuereinrichtung (13, 18) die Gleichstrom-Vorspannung über dem zu untersuchenden Bauelement (3) auf die Ausgangsspannung der Gleichspannungsquelle (11) regelt.

**Revendications**

1. Un appareil pour mesurer un paramètre électrique en courant alternatif d'un dispositif (3) lorsqu'il est relié à celui-ci, comprenant:
   une source de signaux en courant continu (11) pour produire un signal de polarisation en courant continu pour le dispositif (3) en cours de mesure,
   une première borne (A2) pour une connexion au dispositif (3),
   un amplificateur de captage de courant (4, 5) pour faire passer la première borne (A2) à un potentiel de masse virtuelle,
   une seconde borne (A1) pour une connexion au dispositif (3), ladite seconde borne étant reliée à la source de signaux de courant continu (11) pour recevoir le signal de polarisation en courant continu, caractérisé en ce que, pour compenser un décalage de tension continue et/ou un gain fini de l'amplificateur de captage de courant (4, 5) il est prévu un moyen de commande (13, 18) connecté de façon à capter al tension de polarisation continue aux bornes du dispositif (3) et connecté à la source de signaux de courant continu (11) pour régler la tension de polarisation continue aux bornes du dispositif à une valeur sélectionnable, ledit moyen de commande agissant de manière à augmenter le potentiel de la seconde borne (A1) en réponse à une augmentation du potentiel de la première borne (A2) et à réduire le potentiel de la première borne (A1) en réponse à une diminution de potential de la première borne (A2) afin de conserver la différence de potentiel entre la première et la seconde borne à la valeur sélectionnable.

2. Un appareil selon la revendication 1, caractérisé en ce que le moyen de commande (13, 18) comprend:
   un amplificateur de différence (18) pour capter la tension de polarisation continue entre la première et la seconde borne, amplificateur comportant un premier contact d'entrée reliée à la première borne (A2), un second contact d'entrée relié à la seconde borne (A1) et un contact de sortie pour produire un signal de captage représentant la tension de polarisation continue captée; et
   un amplificateur de commande (13) comportant un premier contact d'entrée connecté de façon à recevoir le signal de captage, un second contact d'entrée relié à la source de signaux de courant continu (11) pour recevoir le signal de polarisation en courant continu et un contact de sortie reliée à la seconde borne (A1); et en outre caractérisé en ce que l'amplificateur de commande (13) agit de façon à modifier la tension à la seconde borne (A1) en réponse au fait que le signal de captage est différent du signal de polarisation en courant continu.

3. Un appareil selon la revendication 1 ou 2, caractérisé en ce que la source de signaux de courant continu (11) est une source de tension continue réglable, et en ce que le moyen de commande (13, 18) agit de façon à régler la tension de polarisation continue aux bornes du dispositif en cours de test (3) à la tension de sortie de la source de tension de sortie de la source de tension continue (11).

FIG. 1

FIG. 2

1

FIG. 3

FIG. 4

EP 0 183 996 B1